Europäisches Patentamt

European Patent Office

Office européen des brevets

(11) Publication number: **0 114 435**
**B1**

## (12) EUROPEAN PATENT SPECIFICATION

(45) Date of publication of patent specification: **18.03.87**

(21) Application number: **83201785.9**

(22) Date of filing: **15.12.83**

(51) Int. Cl.⁴: **H 01 L 29/78,** H 01 L 29/06, H 01 L 29/10

(54) Lateral DMOS transistor devices suitable for source-follower applications.

(30) Priority: **21.12.82 US 451993**

(43) Date of publication of application:
**01.08.84 Bulletin 84/31**

(45) Publication of the grant of the patent:
**18.03.87 Bulletin 87/12**

(84) Designated Contracting States:
**DE FR GB NL**

(56) References cited:
**FR-A-2 458 907**
**US-A-3 988 761**
**US-A-4 300 150**

**IEEE TRANSACTIONS ON ELECTRON DEVICES, vol. ED-28, no. 12, December 1981, pages 1455-1466, New York (USA); S. COLAK: "Effects of drift region parameters on the static properties of power LDMOST".**

(73) Proprietor: **N.V. Philips' Gloeilampenfabrieken Groenewoudseweg 1 NL-5621 BA Eindhoven (NL)**

(72) Inventor: **Colak, Sel c/o INT. OCTROOIBUREAU B.V. Prof. Holstlaan 6 NL-5656 AA Eindhoven (NL)**

(74) Representative: **Voorrips, Hugo Carel et al INTERNATIONAAL OCTROOIBUREAU B.V. Prof. Holstlaan 6 NL-5656 AA Eindhoven (NL)**

Courier Press, Leamington Spa, England.

**Description**

Background of the invention:

The invention is in the field of metal-oxide semiconductor (MOS) field-effect devices, and relates specifically to lateral DMOS field-effect transistors suitable for use in source-follower applications. Such transistors are often referred to as double-diffused MOS-transistors, although one or more zones may be made entirely or partly by ion implantation, and their gate electrodes may consist of conductive layers other than metals, for instance of polycristalline silicon. Likewise, the insulating material between gate electrode and semiconductor surface may be another insulator than an oxide, for instance silicon nitride.

A typical prior-art high voltage DMOS transistor is shown on page 1325 of the "IEEE Transactions on Electron Devices", Vol. ED—25, No. 11, November 1978, in a paper entitled "Tradeoff between Threshold Voltage and Breakdown in High-Voltage Double-Diffused MOS Transistors", by Pocha et al. This device includes a semiconductor substrate of a first conductivity type (p-type), a surface adjoining layer-shaped semiconductor region formed by an epitaxial surface layer of a second conductivity type (n-type) on the substrate, a surface-adjoining channel region of the first conductivity type in the epitaxial surface layer, a surface-adjoining source region of the second conductivity type in the channel region, and a surface-adjoining drain contact region of the second conductivity type in the epitaxial surface layer and spaced apart from the channel region. An insulating layer is provided on the surface layer and covers at least that portion of the channel region located between the source and drain. A gate electrode is provided on the insulating layer, over a portion of the channel region between the source and drain and is electrically isolated from the surface layer, while source and drain electrodes are connected respectively to the source and drain regions of the transistor. Such prior-art high-voltage DMOS transistors have a relatively thick surface layer (typically an epitaxial layer), of the order of about 25—30 µm for a breakdown voltage of about 250V, as indicated in the Pocha et al paper. Furthermore, the punchthrough and avalanche breakdown characteristics of these devices relative to their epitaxial layer thickness make them unsuitable for efficient use in applications requiring high voltages.

It has been found that the breakdown characteristics of high-voltage semiconductor devices can be improved using the REduced SURface Field (or RESURF) technique, as described in "High Voltage Thin Layer Devices (RESURF Devices)", "International Electron Devices Meeting Technical Digest", December 1979, pages 238—241, by Appels et al, and US—A—4 292 642 to Appels et al. Essentially, the improved breakdown characteristics of these RESURF devices are achieved by employing thinner but more highly doped epitaxial layers to reduce surface fields.

The RESURF technique was applied to lateral DMOS transistors of the prior-art type described above, as reported in "Lateral DMOS Power Transistor Design", IEEE Electron Device Letters", Vol. EDL—1, No. 4, pages 51—53, April 1980, by Colak et al and US—A—4 300 150, and the result was a substantial improvement in device characteristics. It should be understood that in high-voltage DMOS devices, there is always a trade-off between breakdown voltage, on-resistance and device size, with the goal being to increase the breakdown voltage level while maintaining a relatively low on-resistance in a relatively compact device. Using the prior art RESURF technique, and for reference assuming a constant breakdown voltage of about 400 volts, a very substantial improvement (e.g. decrease) in on-resistance may be obtained in a device of the same size as a conventional (thick epitaxial layer) DMOS device.

However, such prior art RESURF devices, with their thin epitaxial layers, are not suitable for use in source-follower applications or other circuit arrangements where both the source and drain are at a high potential with respect to the substrate. For such applications, these devices would require a substantially thicker epitaxial surface layer, thus negating a principal advantage of the RESURF technique and increasing device size and cost, or they would require a lower epitaxial doping level, which would increase on-resistance, again negating a principal advantage of the RESURF technique.

Summary of the invention:

It is therefore an object of the present invention to provide a lateral DMOS transistor which is suitable for use in source-follower applications or other circuit arrangements where both the source and drain are at a high potential with respect to the substrate.

It is a further object of the invention to provide a lateral DMOS transistor suitable for source-follower applications while maintaining the advantage of devices constructed using the RESURF technique.

In accordance with the invention, these objectives are achieved by a lateral DMOS transistor of the type described in US—A—4 300 150, in which the single prior-art surface layer on the semiconductor substrate is replaced by a 3-layer configuration including a first semiconductor layer of the second conductivity type on the substrate, a second semiconductor layer of the first conductivity type on the first layer, and a third semiconductor surface layer of the second conductivity type on the second layer. The surface-adjoining channel region is connected to the second layer forming thereby an extension of the channel region to beneath the drain contact region and the extended drain region is formed from a portion of the third layer between the drain contact region and the channel region. This 3-layer configuration permits operation in the source-follower mode by preventing device breakdown when both the source and drain are operated at relatively high voltages with respect to the substrate.

In a further embodiment of the invention, a plurality of spaced-apart semiconductor zones of the second conductivity type are located within that portion of the second semiconductor layer extending from adjacent the channel region to beneath the drain contact region. These semiconductor zones may either be strip-shaped zones which extend continuously from adjacent the channel region to beneath the drain contact region or else each zone may include first and second subzones, with the first subzone located adjacent to the channel region and the second subzone spaced apart from the first subzone and located beneath the drain contact region of the device. These semiconductor zones serve to prevent the first semiconductor layer from floating by connecting it to the third semiconductor surface layer of the device, and also provide an additional RESURF effect in the lateral direction, thus improving both breakdown voltage and device conductivity.

In another embodiment of the invention, device conductivity can be further improved by providing a second drain region and a further gate electrode, so that the second semiconductor layer can also contribute to device conductivity when the transistor is in the "on" state.

Brief description of the drawing:

Fig. 1 is a vertical cross-sectional view of a lateral DMOS transistor in accordance with a first embodiment of the invention;

Fig. 2A is a plan view along the section line 2—2 of the transistor of Fig. 1;

Fig. 2B is a plan view of a lateral DMOS transistor in accordance with a second embodiment of the invention;

Fig. 2C is a plan view of a lateral DMOS transistor in accordance with a third embodiment of the invention; and

Fig. 3 is a vertical cross-sectional view of a lateral DMOS transistor in accordance with a fourth embodiment of the invention.

Detailed description:

As noted above, conventional lateral DMOS transistors are not suitable for efficient use in source-follower circuits, because of the relatively thick epitaxial layers required to avoid punchthrough breakdown in the source-follower mode. This results in an unduly large and expensive-to-manufacture device. Furthermore, prior-art RESURF techniques, which permit the use of thinner epitaxial layers, result in devices which are unsuited for source-follower applications because of similar high-voltage breakdown problems. More specifically, in typical source-follower applications, the device substrate is normally grounded, while the drain, source and channel regions of the device experience high voltage levels in the "on" state when these devices are operated with high power supply voltages. Under such conditions, conventional RESURF devices are subject to punchthrough breakdown (from channel to substrate) which precludes operation in the source-follower mode.

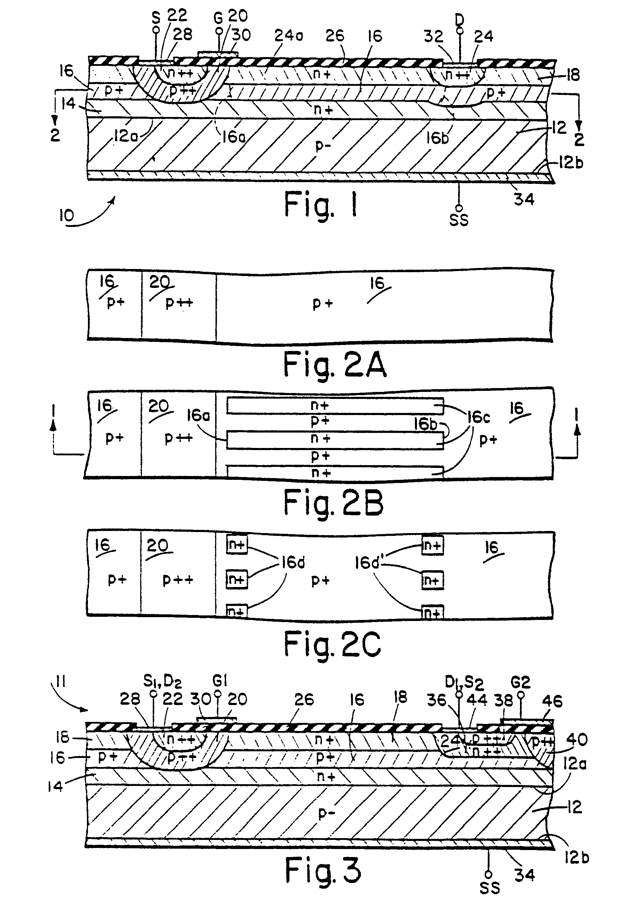

These prior-art problems are overcome in the present invention by a device such as that shown in Fig. 1, employing a triple-layer structure above the substrate. It should be noted that Fig. 1, as well as the remaining Figures of the drawing, are not drawn to scale, and in particular the vertical dimensions are exaggerated for improved clarity. Additionally, like parts are designated with like reference numerals in the various figures, and semiconductor regions of the same conductivity type are shown hatched in the same direction.

In Fig. 1, a lateral DMOS transistor 10 has a semiconductor substrate 12 of a first conductivity type, here p-type, on which the device is constructed. A first semiconductor layer 14 of a second conductivity type opposite to that of the first, here n-type, is located on a first major surface 12a of the substrate, while a second semiconductor layer 16 of the first conductivity type is located on the first semiconductor layer. The basic layered construction of the device is completed by a third semiconductor surface layer 18 of the second conductivity type which is located on the second layer.

The lateral DMOS transistor of the invention is constructed within this layered structure by providing a first surface-adjoining channel region 20 of p-type material in the third layer, with a surface-adjoining source region 22 of n-type material in a portion of p-type region 20. A first surface-adjoining drain contact region 24 of n-type material is provided in the third layer 18 and is spaced apart from the first channel region, and a portion of the third semiconductor surface layer 18 between the drain contact region 24 and the first channel region 20 forms an extended drain region 24a. Similarly, that portion of the second layer extending from the channel region 20 to beneath the first drain contact region 24 forms an extended channel region.

An insulating layer 26 is provided on the surface of the transistor, over the third surface layer, and covers at least the portion of the first channel region 20 which is located between the source and the first drain regions. A first gate electrode 30 is provided on the insulating layer 26, over the previously-mentioned portion of the first channel region, and is electrically isolated from the third layer by the insulating layer 26. An electrical connection to the first drain contact region 24 is provided by a first drain electrode 32, while a source electrode 28 is provided to contact the source region 22, and this source electrode also serves to connect the first channel region 20 to the source region 22. The basic construction of the device is completed by a substrate electrode 34 on lower major surface 12b of the substrate 12.

The principal difference between the present invention and prior-art lateral DMOS transistors, such as Fig. 1 of US—A—4 300 150 lies in the presence of the second semiconductor layer 16, which in Fig. 1

forms a p-type extension of the channel region 20 between the n-type first and third semiconductor layers, and which extends from the channel region 20 to beneath the drain region 24, 24a. This configuration is in contrast to the prior art device shown in Fig. 1 of US—A—4 300 150 in which the area between the channel and drain is composed of a single n-type layer 12.

The three-layer configuration of the present invention affords several important design advantages, which permit the use of devices incorporating the present invention in source-follower circuits. In particular, by providing an extended channel in the form of second semiconductor layer 16, it is possible to increase the doping levels of the n-type first and third semiconductor layers to substantially avoid the channel-to-substrate punchthrough breakdown problems previously described. Ordinarily, such an increased doping level would be undesirable because it would reduce the drain-to-channel avalanche breakdown voltage of the device, but here, by adding the p-type second semiconductor layer, this undesirable decrease in avalanche breakdown voltage is substantially avoided. By redistributing the electrical field over a greater area of the device, the p-type second semiconductor layer utilizes the basic RESURF principle to reduce the localized magnitude of the electrical field adjacent the channel, and thus prevents avalanche breakdown in this region when higher doping levels are used in the third, and particularly the first, semiconductor layers in order to prevent punchthrough during operation in the source-follower mode. Thus, the present invention results in a device which is particularly suitable for high-voltage operation in the source-follower mode due to its improved punchthrough and avalanche breakdown characteristics.

Furthermore, in accordance with basic RESURF principles, the three semiconductor layers are not only more highly-doped than in conventional devices, but are also substantially thinner, thus resulting in a smaller, less expensive and easier-to-manufacture device. Thus, while the total thickness of all three semiconductor layers (i.e. the total thickness between insulating layer 26 and the upper surface 12a of the substrate) may typically be about 6 $\mu$m in the present invention for a device capable of operating at 400 volts, the prior-art MOS structure of Pocha et al, described above, requires an epitaxial layer thickness of greater than 23 $\mu$m in order to achieve a punchthrough breakdown voltage of only 200 volts. In addition, the relatively high doping levels of the semiconductor layers in the present invention provide improved normalized "on" resistance despite the use of relatively thin semiconductor layers. Thus, the present invention serves to improve both breakdown voltage and normalized "on" resistance, thereby permitting effective and efficient operation in the source-follower mode.

While the configuration of the present invention can be advantageously used in various device constructions, the following table of approximate values will illustrate the configuration of a typical device having a breakdown voltage of about 400 volts:

| REGION (Ref. No.) | TYPE | TYPICAL DOPING | TYPICAL THICKNESS [$\mu$m] |
|---|---|---|---|
| First semiconductor layer (14) | n+ | $10^{16}$ donors/cm$^3$ | 2 |
| Second semiconductor layer (16) | p+ | $10^{16}$ acceptors/cm$^3$ | 2 |
| Third semiconductor layer (18) | n+ | $10^{16}$ donors/cm$^3$ | 2 |
| Source (22) | n++ | $10^{18}$—$10^{20}$ donors/cm$^3$ | 2 |
| Drain Contact (24) | n++ | $10^{18}$—$10^{20}$ donors/cm$^3$ | 2 |
| Channel (20) | p++ | $10^{17}$—$10^{20}$ acceptors/cm$^3$ | 4 |
| Substrate (12) | p− | $10^{14}$—$10^{15}$ acceptors/cm$^3$ | — |

A plan view of the device of Fig. 1 along the section line 2—2 is shown in Fig. 2A. This plan view shows a horizontal section of the p-type second semiconductor layer 16, as well as a portion of the more highly-doped channel region 20 which extends into the second semiconductor layer beneath the source. Due to the substantially continuous nature of this intermediate p-type layer between the upper (third) and lower (first) semiconductor layers, the lower n-type semiconductor layer does not conduct a portion of the total device current in the "on" state because layer 14 is isolated from the current-carrying path due to the intervening second semiconductor layer 16. However, substantial further reduction in normalized "on" resistance could be attained if the first semiconductor layer 14 of Fig. 1 were to be used as an additional current path. Two alternate embodiments for accomplishing this function are shown in Figs. 2B and 2C.

In these embodiments, a plurality of spaced-apart semiconductor zones 16c, 16d of the second conductivity type (here n-type) are located within that portion of the second semiconductor layer 16 extending from adjacent the channel region 20 to beneath the drain contact region 24. In Fig. 2B, these semiconductor zones are formed from strip-shaped zones 16c which extend continuously from adjacent the channel region to beneath the drain contact region, while in Fig. 2C, each spaced-apart semiconductor zone is formed from a first sub-zone 16d located adjacent the channel region and a second sub-zone 16d' which is spaced apart from the first sub-zone and is located beneath the drain contact region. These spaced-apart semiconductor zones 16c, 16d and 16d' are n-type zones having a typical doping level of about $10^{16}$ donors/cm$^3$. In Fig. 2B, the lateral extent of the semiconductor zones 16c is shown by reference numerals 16a and 16b to denote the left and right edges, respectively, of the zones. In Fig. 1, dotted lines are used to show where these left and right edges would appear in a cross-section along the line 1—1 of Fig. 2B if these semiconductor zones were to be incorporated into the device of Fig. 1. As shown in Fig. 1, the semiconductor zones extend in the vertical direction from the third semiconductor layer 18 down to the first semiconductor layer 14.

By means of these semiconductor zones, a connection is formed between the upper (third) and lower (first) semiconductor layers, so that the first semiconductor layer is no longer floating, and can contribute to device conductivity in the "on" state, thus lowering normalized "on" resistance. In fact, normalized "on" resistance will be reduced by a factor of about 2 by including these semiconductor zones in the embodiment of Fig. 1. Additionally, by preventing the lower (first) semiconductor layer from floating by connecting it to the uppermost (third) semiconductor layer, an additional advantage is obtained in that the avalanche breakdown voltage of the device will be increased. Furthermore, with these zones, the critical nature of the upper (third) semiconductor layer decreases, so that it can be made thinner.

An additional embodiment of the invention, in which device conductivity is further improved, is shown in Fig. 3. This device differs from the device shown in Fig. 1 basically in that the single gate and drain structure of Fig. 1 is replaced by a modified dual-gate/dual-drain structure. More particularly, lateral DMOS transistor 11 includes a second surface-adjoining drain end region 40 of p-type material, as well as a second surface-adjoining channel region 36 of n-type material which is controlled by a further gate electrode 46 (G2) located over the second channel region. The embodiment of Fig. 3 also differs from the previously described embodiment of Fig. 1 in that the original drain contact region 24 (hereinafter referred to as the first drain contact region for clarity) now includes a p-type surface region 38 within the n-type region 36, so that region 36 now also serves as a second surface-adjoining channel region for the new portion (on its right side), while the p-type zone 38 serves as a further surface-adjoining source region for the new portion of the device. A first drain electrode 44 contacts both source region 38 and region 36, and now serves as both a drain electrode (D1) for the original portion of the device and as a source electrode (S2) for the new portion. The purpose of this more complex dual-gate/dual-drain structure is to enhance device conductivity in the "on" state by enabling the second p-type semiconductor layer 16 to also contribute to device conductivity by conducting holes from region 38, through the second channel region 36, the second drain end region 40 and the second semiconductor layer 16 back to source region 22. Electrode 28, which contacts both regions 20 and 22, now serves as both a source electrode (S1) for the original portion of the device and as a drain electrode (D2) for the new portion.

Yet a further improvement in normalized "on" resistance may be achieved by combining the dual-gate/dual drain structure of Fig. 3 with the spaced-apart semiconductor zones 16c or 16d/d' of Fig. 2B or 2C. In this manner all three semiconductor layers will contribute to device conductivity, thus achieving optimum normalized "on" resistance.

Thus, by using a unique triple-layer construction, the present invention provides a lateral DMOS transistor which is capable of operating at high voltages in the source-follower mode, while at the same time providing a low normalized "on" resistance in a vertically compact and easily manufactured structure.

## Claims

1. A lateral DMOS transistor comprising a semiconductor substrate of a first conductivity type, a layer-shaped semiconductor region on a first major surface of said substrate and forming a pn-junction with said substrate, a first surface-adjoining channel region of said first conductivity type in said layer-shaped region, a surface-adjoining source region of a second conductivity type opposite to that of the first conductivity type in said channel region, a first surface-adjoining drain contact region of said second conductivity type in said layer-shaped region and separated from said first channel region by an extended drain region formed by a portion of said layer-shaped region, an insulating layer on the surface of said transistor and covering at least that portion of the first surface-adjoining channel region located between said source region and said extended drain region, a first gate electrode on said insulating layer over at least said portion of the first channel region, and source-and first drain electrodes connected respectively to the source-and first drain contact regions, characterized in that said layer-shaped semiconductor region is composed of a first layer of said second conductivity type on said substrate, a second layer of said first conductivity type on said first layer and a third surface-adjoining layer of said second conductivity type on said second layer, in that said first surface-adjoining channel region is connected to said second layer forming thereby an extension of the channel region to beneath the first drain contact region, and in that said extended drain region is formed from a portion of said third layer between said first drain contact region and said first channel region.

**0 114 435**

2. A lateral DMOS transistor as in Claim 1, wherein the doping level of said second layer is higher than that of said substrate, the doping level of said first channel region is higher than that of said second layer, and the doping level of said source and first drain contact regions is higher than the doping level of said first and third layers.

3. A lateral DMOS transistor as in Claim 2, wherein said source electrode electrically connects said source and first channel regions together, and further comprising a substrate electrode on a second major surface of said substrate opposite to said first major surface.

4. A lateral DMOS transistor as in Claim 1, further comprising a plurality of spaced-apart semiconductor zones of said second conductivity type located in that portion of said second semiconductor layer extending laterally from adjacent said first channel region to beneath said first drain contact region, said semiconductor zones extending vertically from said first semiconductor layer to said third semiconductor layer.

5. A lateral DMOS transistor as claimed in Claim 4, wherein said spaced-apart zones comprise strip-shaped zones extending continuously from adjacent said first channel region to beneath said first drain contact region.

6. A lateral DMOS transistor as claimed in Claim 4, wherein each of said spaced-apart zones comprises a first subzone located adjacent said first channel region and a second subzone, spaced apart from said first subzone and located beneath said first drain contact region.

7. A lateral DMOS transistor as claimed in Claim 4, wherein said spaced-apart semiconductor zones comprise n-type zones having a doping level of about $10^{16}$ donors/cm$^3$.

8. A lateral DMOS transistor as in Claim 1 or in one of the claims 4 to 6, further comprising a second surface-adjoining drain end region of said first conductivity type in said third layer, connected to said second layer, and electrically isolated from said first drain contact region by a p-n junction, a second surface-adjoining channel region of said second conductivity type between said first drain contact region and said second drain end region, said insulating layer on the surface of said transistor further covering that portion of the second surface-adjoining channel region located between said drain regions, a further surface-adjoining source region of said first conductivity type in said second surface-adjoining channel region and connected to said first drain electrode, and a further gate electrode on said insulating layer, over said portion of the second channel region and electrically isolated from said third layer.

9. A lateral DMOS transistor as in Claim 1, wherein said first and third semiconductor layers comprise n-type layers having a doping level of about $10^{16}$ donors/cm$^3$ and a thickness of about 2μm, and said second semiconductor layer comprises a p-type layer having a doping level of about $10^{16}$ acceptors/cm$^3$ and a thickness of about 2 μm.

**Patentansprüche**

1. Lateraler DMOS-Transistor mit einem Halbleitersubstrat eines ersten Leitungstyps, einem schichtförmigen Halbleitergebiet auf einer ersten Hauptfläche des genannten Substrats, das mit dem genannten Substrat einen PN-Übergang bildet, einem ersten an die Oberfläche grenzenden Kanalgebiet des genannten ersten Leitungstyps in dem genannten schichtförmigen Gebiet, einem an die Oberfläche grenzenden Source-Gebiet eines zweiten Leitungstyps, der dem ersten Leitungstyp in dem genannten Kanalgebiet entgegengesetzt ist, einem ersten an die Oberfläche grenzenden Drain-Kontaktgebiet des genannten zweiten Leitungstyps in dem genannten schichtförmigen Gebiet, das durch ein erweitertes Drain-Gebiet, das durch einen Teil des genannten schichtförmigen Gebietes gebildet wird, von dem gennanten ersten Kanalgebiet getrennt ist, einer Isolierschicht auf der Oberfläche des genannten Transistors, die wenigstens denjenigen Teil des ersten an die Oberfläche grenzenden Kanalgebietes zwischen dem genannten Source-Gebiet und dem genannten erweiterten Drain-Gebiet bedeckt, einer ersten Gate-Elektrode auf der genannten Isolierschicht über wenigstens den genannten Teil des ersten Kanalgebietes und mit einer Source- und ersten Drain-Elektrode, die mit dem Source- bzw. ersten Drain-Kontaktgebiet verbunden ist, dadurch gekennzeichnet, dass das genannte schichtförmige Halbleitergebiet aus einer esten Schicht des genannten zweiten Leitungstyps auf dem genannten Substrat, einer zweiten Schicht des genannten ersten Leitungstyps auf der genannten ersten Schicht und einer dritten an die Oberfläche grenzenden Schicht des genannten zweiten Leitungstyps auf der genannten zweiten Schicht besteht, dass der genannte erste an die Oberfläche grenzende Kanalgebiet mit der genannten zweiten Schicht verbunden ist, die dadurch eine Erweiterung des Kanalgebietes bis unter das erste Drain-Kontaktgebiet bildet, und dass das gennante erweiterte Drain-Gebiet aus einem Teil der genannten dritten Schicht zwischen dem genannten ersten Drain-Kontaktgebiet und dem genannten ersten Kanalgebiet gebildet ist.

2. Lateraler DMOS-Transistor nach Anspruch 1, dadurch gekennzeichnet, dass der Dotierungspegel der genannten zweiten Schicht höher ist als der des Substrates, wobei der Dotierungspegel des genannten ersten Kanalgebietes höher ist als der der genannten zweiten Schicht und der Dotierungspegel des genannten Source- und ersten Drain-Kontaktgebietes höher ist als der Dotierungspegel der genannten ersten und dritten Schicht.

3. Lateraler DMOS-Transistor nach Anspruch 2, dadurch gekennzeichnet, dass die genannte Source-Elektrode das genannte Source-und erste Kanalgebiet elektrisch miteinander verbindet und weiterhin eine Substratelektrode auf einer zweiten Hauptoberfläche des genannten Substrates gegenüber der genannten ersten Hauptoberfläche aufweist.

4. Lateraler DMOS-Transistor nach Anspruch 1, dadurch gekennzeichnet, dass er weiterhin eine Anzahl räumlich getrennter Halbleiterzonen des genannten zweiten Leitungstyps aufweist, die in demjenigen Teil der genannten zweiten Halbleiterschicht vorgesehen sind, der sich lateral von dem genannten ersten Kanalgebiet bis unter das genannte erste Drain-Kontaktgebiet erstreckt, wobei die genannten Halbleiterzonen sich vertikal von der genannten ersten Halbleiterschicht zu der genannten dritten Halbleiterschicht erstrecken.

5. Lateraler DMOS-Transistor nach Anspruch 4, dadurch gekennzeichnet, dass die genannten räumlich getrennten Zonen streifenförmige Zonen aufweisen, die sich ununterbrochen von dem angrenzenden genannten ersten Kanalgebiet bis unter das genannte erste Drain-Kontaktgebiet erstrecken.

6. Lateraler DMOS-Transistor nach Anspruch 4, dadurch gekennzeichnet, dass jede der räumlich getrennten Zonen eine erste Teilzone aufweist, die an das genannte erste Kanalgebiet grenzend vorgesehen ist und eine zweite Teilzone, die von der genannten ersten Teilzone räumlich getrennt und unter dem genannten ersten Drain-Kontaktgebiet vorgesehen ist.

7. Lateraler DMOS-Transistor nach Anspruch 4, dadurch gekennzeichnet, dass die genannten räumlich getrennten Halbleiterzonen n-leitende Zonen mit einem Dotierungspegel von etwa $10^{16}$ Donoren/cm$^3$ aufweisen.

8. Lateraler DMOS-Transistor nach Anspruch 1 oder einem der Ansprüche 4 bis 6, dadurch gekennzeichnet, dass er weiterhin ein zweites an die Oberfläche grenzendes Drain-Endgebiet des genannten ersten Leitungstyps in der genannten dritten Schicht aufweist, das mit der genannten zweiten Schicht verbunden und durch einen PN-Übergang von dem genannten ersten Drain-Kontaktgebiet elektrisch isoliert ist, weiterhin ein zweites an die Oberfläche grenzendes Kanalgebiet des genannten zweiten Leitungstyps zwischen dem genannten ersten Drain-Kontaktgebiet und dem genannten zweiten Drain-Endgebiet, wobei die genannte Isolierschicht auf der Oberfläche des genannten Transistors weiterhin denjenigen Teil des zweiten an die Oberfläche grenzenden Kanalgebietes bedeckt, der zwischen den genannten Drain-Gebieten liegt, ein weiteres an die Oberfläche grenzendes Source-Gebiet des genannten ersten Leitungstyps in dem genannten zweiten an die Oberfläche grenzenden Kanalgebiet und mit der genannten ersten Drain-Elektrode verbunden, und eine weitere Gate-Elektrode auf der genannten Isolierschicht, die über den genannten teil des zweiten Kanalgebiets liegt und gegenüber der genannten dritten Schicht elektrisch isoliert ist.

9. Lateraler DMOS-Transistor nach Anspruch 1, dadurch gekennzeichnet, dass die genannte erste und dritte Halbleiterschicht eine n-leitende Schicht mit einem Dotierungspegel von etwa $10^{16}$ Donoren/cm$^3$ und mit einer Dicke von etwa 2 μm aufweisen und dass die genannte zweite Halbleiterschicht eine p-leitende Schicht mit einem Dotierungspegel von etwa $10^{16}$ Akzeptoren/cm$^3$ und mit einer Dicke von etwa 2 μm aufweist.

**Revendications**

1. Transistor DMOS latéral comportant un substrat semiconducteur d'un premier type de conductivité, une région semiconductrice en forme de couche située sur une première surface principale dudit substrat et formant une jonction pn avec ce substrat, une première région de canal dudit premier type de conductivité contigué à la surface et située dans ladite région en forme de couche, une région de source d'un second type de conductivité, opposé au premier, contigué à la surface et située dans ladite région en forme de couche, une région de source d'un second type de conductivité, opposé au premier, contiguë à la surface et située dans ladite région de canal, une première région de contact de drain dudit second type de conductivité contiguë à la surface et située dans ladite région en forme de couche tout en étant séparée de ladite première région de canal par une région de drain prolongée formée par une partie de ladite région en forme de couche, une couche isolante située sur la surface dudit transistor et recouvrant au moins la partie de la première région de canal contiguë à la surface, située entre ladite région de source et ladite région de drain prolongée, une première électrode de grille située sur ladite couche isolante, au-dessus d'au moins ladite partie de la première région de canal, et une électrode de source et une première électrode de drain reliée respectivement à la région de source et à la première région de contact de drain, caractérisé en ce que ladite région semiconductrice en forme de couche est constituée d'une première couche dudit second type de conductivité située sur ledit substrat, d'une deuxième couche dudit premier type de conductivité située sur ladite première couche et d'une troisième couche dudit second type de conductivité contiguë à la surface et située sur ladite deuxième couche, en ce que ladite première région du canal contiguë à la surface est reliée à ladite deuxième couche tout en formant un prolongement de la région de canal jusqu' au-dessous de la première région de contact de drain, et en ce que ladite région de drain prolongée est formée par une partie de ladite troisième couche, située entre ladite première région de contact de drain et ladite première région de canal.

2. Transistor DMOS latéral selon la revendication 1, caractérisé en ce que le niveau de dopage de ladite deuxième couche est supérieur à celui dudit substrat, en ce que le niveau de dopage de ladite première région de canal est supérieur à celui de ladite deuxième couche, est en ce que le niveau de dopage de ladite région de source et de ladite première région de contact de drain est supérieur au niveau de dopage desdites première et troisième couches.

3. Transistor DMOS latéral selon la revendication 2, caractérisé en ce que ladite électrode de source interconnecte ladite région de source et ladite première région de canal, alors qu'il comporte en outre une électrode de substrat prévue sur une seconde surface principale dudit substrat, située à l'opposé de ladite première surface principale.

4. Transistor DMOS latéral selon la revendication 1, comportant en outre une pluralité de zones semiconductrices espacées dudit second type de conductivité situées dans la partie de ladite deuxième couche semiconductrice qui s'étend latéralement d'à côté de ladite première région de canal jusqu' au-dessous de ladite première région de contact de drain, lesdites zones semiconductrices s'étendant verticalement à partir de ladite première couche en semiconductrice jusqu' à ladite trousième couche semiconductrice.

5. Transistor DMOS latéral selon la revendication 4, caractérisée en ce que lesdites zones espacées comportent des zones en forme de bande s'étendant de façon continue d'à côté de ladite première région de canal jusqu'au-dessous de ladite première région de contact de drain.

6. Transistor DMOS latéral selon la revendication 4, caractérisé en ce que chacune desdites zones espacées comporte une première sous-zone située à côté de ladite première région de canal et une seconde sous-zone séparée de ladite première sous-zone et située au-dessous de ladite première région de contact de drain.

7. Transistor DMOS latéral selon la revendication 4, caractérisé en ce que lesdites zones semiconductrices espacées comportent des zones de type n ayant un niveau de dopage de l'ordre de $10^{16}$ donneurs/cm$^3$.

8. Transistor DMOS latéral selon la revendication 1 ou l'une des revendications 4 à 6, comportant en outre une seconde région de drain terminale dudit premier type de conductivité contiguë à la surface et située dans ladite troisième couche, seconde région de drain terminale qui est reliée à ladite deuxième couche et qui est électriquement isolée de ladite première région de contact de drain par une jonction pn, puis une seconde région de canal du second type de conductivité contiguë à la surface et située entre ladite première région de contact de drain et ladite seconde région de drain terminale, ladite couche isolante sur la surface dudit transistor recouvrant en outre la partie de la seconde région de canal, contiguë à la surface, située entre lesdites régions de drain, ensuite une autre région de source dudit premier type de conductivité contiguë à la surface et située dans ladite seconde région de canal contiguë à la surface tout en étant reliée à ladite première électrode de drain et, finalement, une autre électrode de grille située sur ladite couche isolante, au-dessus de ladite partie de la seconde région de canal, et électriquement isolée de ladite troisième couche.

9. Transistor DMOS latéral selon la revendication 1, caractérisé en ce que lesdites première et troisième couches semiconductrices comportent des couches de type n ayant un niveau de dopage de l'ordre de $10^{16}$ donneurs/cm$^3$ et une épaisseur de l'ordre de 2 µm, et en ce que ladite deuxième couche semiconductrice comporte une couche de type p ayant un niveau de dopage de l'ordre de $10^{16}$ accepteurs/cm$^3$ et une épaisseur de l'ordre de 2 µm.

0 114 435

Fig. 1

Fig. 2A

Fig. 2B

Fig. 2C

Fig. 3